# EUROPEAN PATENT SPECIFICATION

(11) **EP 2 325 592 B1**
(45) Date of publication and mention of the grant of the patent: **01.02.2012**
(21) Application number: 09014499.9
(22) Date of filing: 20.11.2009
(51) Int. Cl.: F28D 15/02, B21D 53/06, H01L 23/427, H01L 21/48

(54) **Method and fixture for manufacturing coplanar evaporators with multiple heat pipes and evaporator obtained by this method**
Verfahren und Befestigung zum Herstellen von koplanaren Verdampfern aus Wärmrohren sowie dadurch hergestellter Verdampfer
Procédé et fixation pour la fabrication d'évaporateurs coplanaires avec plusieurs caloducs et évaporateur obtenu par ledit procédé

(43) Date of publication of application: 25.05.2011
(73) Proprietor: CPUMATE INC., Taipei County 248 (TW); Golden Sun News Techniques Co., Ltd., Taipei County 248 (TW)
(72) Inventor: Lin, Kuo-Len, Wugu Township Taipei County 248 (TW); Lin, Chen-Hsiang, Wugu Township Taipei County 248 (TW); Hung, Mong-Hua, Wugu Township Taipei County 248 (TW); Hsu, Ken, Wugu Township Taipei County 248 (TW); Cheng, Chih-Hung, Wugu Township Taipei County 248 (TW)
(74) Representative: Urner, Peter

(56) References cited:
- EP-A1- 1 921 410
- DE-A1-102006 052 753
- US-A1- 2006 144 571
- US-A1- 2006 291 166
- US-A1- 2007 261 244
- US-A1- 2009 266 522

## Description

### BACKGROUND OF THE INVENTION

### Field of the Invention

The present inventions relates to a manufacturing method of coplanar evaporators of multiple heat pipes, and to a structure of such evaporators and a fixture for manufacturing thereof, (see for example EP-A-1 921 41C which discloses a method with the steps (a), (c) and (d) of claim 1.)

### Description of Prior Art

Accordingly, when a common heat pipe is applied as a cooling device for an electronic product, one side of the heat pipe is thermally connected to an electronic heating component, while another side is arranged by passing a plurality of cooling fins therethrough. Through the high thermal conductivity of the heat pipe, the heat generated by the electronic heating component can be transferred into each cooling fins via heat pipe, whereby the heat is dissipated into the ambiance, subsequently lowing down the temperature of the electronic component. In the meantime, the heat accumulated in each cooling fins can also be dissipated by means of cooling fans, thus an excellent cooling effect being able to achieve.

Since the profile section of the heat pipe is substantially shown as a tubular configuration, its area is not big enough even after pressed flatly. Therefore, in a usual practice, the heat pipe is first connected to a thermally conductive plate, which is then attached onto the surface of an electronic heating component. However, in this kind of manner, it is impossible for the heat pipe to make a direct and close contact with the electronic heating component, thus the inherent performance of the heat pipe being unable to develop completely. On the one hand, since the thermally conductive plate is made of a material of copper, its weight is heavy and the purchasing cost is high. On the other hand, if the copper material is replaced by an aluminum material, which has a lighter weight, however, the thermally conductive performance will be influenced, because of its poor thermal conductivity. Therefore, a flatly rolled heat pipe is adapted by some practices; namely, the heated side of the heat pipe is formed as a flat configuration for facilitating a tight contact with the surface of an electronic heating component, as disclosed in a Taiwan Utility Model Publication No.: M248231 titled as "Heat Pipe Cooling Device".

Nonetheless, in flatly rolling a heat pipe according to the aforementioned method, on the one hand, when the flatly pressed area is small, the heated side of the heat pipe is insufficiently to cover the entire surface of the electronic heating component. On the other hand, in order to flatly roll out a sufficiently large area capable of thermal conduction, the tube will be broken when flatly rolled, if the thickness of the tubular wall can not stand the excessively rolling pressure.

Accordingly, after a substantially devoted study, in cooperation with the application of relative academic principles, the inventor has finally proposed the present invention designed reasonably to possess the capability to improve the drawbacks of the prior arts significantly.

### SUMMARY OF THE INVENTION

Therefore, in order to solve aforementioned problems, the invention is mainly to provide a manufacturing method, finished product and fixture of coplanar evaporators of multiple heat pipes. During implementation, the evaporators of the multiple heat pipes can make a directly thermal conduction with the electronic heating component. In the meantime, the coplanar configuration constituted by the heated faces of the evaporators of the multiple heat pipes has a larger area, which is able to completely and closely cover the upper surface of the electronic heating component

The invention thus provides a manufacturing method of coplanar evaporators of multiple heat pipes, including following steps:
a) Providing a plurality of heat pipes, each of which has an evaporator formed a heated face thereon;
b) Moving the evaporators closely to one another in a manner, thus their heated faces being disposed onto a flat face;
c) Limiting the evaporators from multiple directions;
d) Pressing the evaporators toward the flat face to make their heated faces flush therewith;
e) Injecting bonding media into the gaps among the heat faces of the evaporators to bond the heat faces together and form a fixedly coplanar configuration.

Moreover, the invention provides a structure of coplanar evaporators of multiple heat pipes according to claim 5.

Furthermore, the invention provides a fixture for manufacturing coplanar evaporators of multiple heat pipes, adapted for aligning the evaporators of multiple heat pipes closely to form a coplanar configuration according to claim 7.

### BRIEF DESCRIPTION OF DRAWING

The invention itself, however, may be best understood by reference to the following detailed description, which describes a number of preferred embodiments of the invention, taken in conjunction with the accompanying drawings, in which:
Fig. 1 is a flow diagram according to the present invention;
Fig. 2 is a perspective explosive view of the multiple heat pipes according to a preferred embodiment of the present invention;
Fig. 3 is a perspective explosive view of both the multiple heat pipes and the fixture according to a preferred embodiment of the present invention;
Fig. 4 is a perspective assembled view of both the multiple heat pipes and the fixture according to a preferred embodiment of the present invention;
Fig. 5 is an assembled sectional view of both the multiple heat pipes and the fixture according to a preferred embodiment of the present invention;
Fig. 6 is a partially enlarging view based on Fig. 5;
Fig. 7 is a partially enlarging view of the evaporators of the heat pipes based on Fig. 5;
Fig. 8 is a perspective explosive view of a fixture according to another preferred embodiment of the present invention; and
Fig. 9 is perspective assembled view of a fixture according to another preferred embodiment of the present invention.

### DETAILED DESCRIPTION OF THE INVENTION

In cooperation with attached drawings, the technical contents and detailed description of the present invention are described thereinafter according to a number of preferable embodiments, not used to limit its executing scope as defined by the claims. Any equivalent variation and modification made within the scope of the appended claims is covered by the present invention.

The invention is to provide a manufacturing method, finished product and fixture of coplanar evaporators of multiple heat pipes. Mainly, after the evaporators 10 of the multiple heat pipes I are aligned closely to one another, a bonding media 12 is filled into the gaps among the heated faces 100 under each evaporators 10, whereby each evaporators 10 are bonded together, making the bonding media 12 and each heated faces 100 formed into a coplanar configuration.

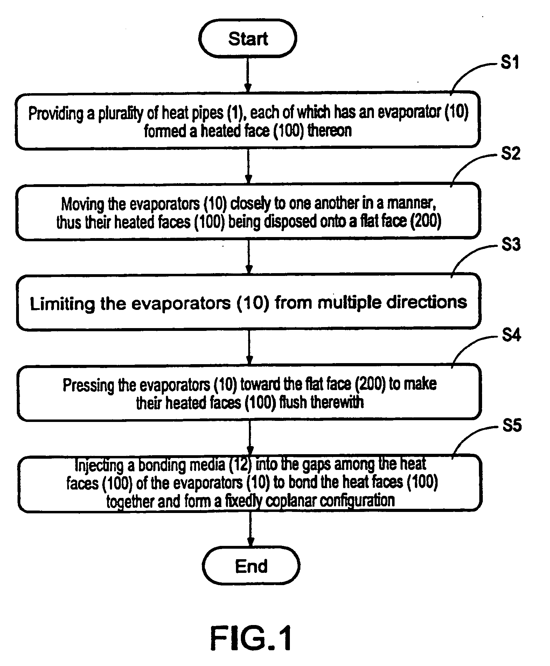

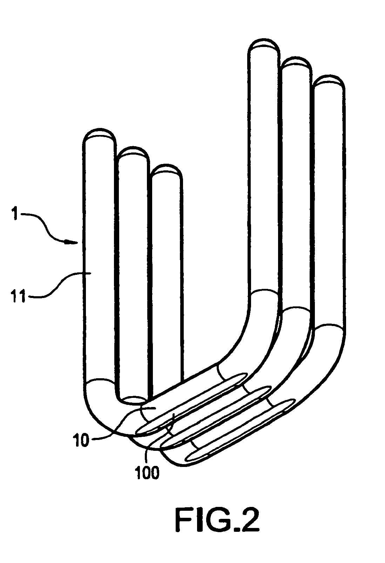

Please refer to step S1 of Fig. 1, also as shown in Fig 2: first, providing a plurality of heat pipes 1, each of which has an evaporator 10 and a condenser 11. The evaporator 10 is adapted to contact a heat source, such as, an electric heating component (not shown in the figures), while the condenser 11 can be passed through by a plurality of cooling fins (not shown in the figures) for cooling purpose. There is a heated face 100 at the bottom face of the evaporator 10. Making the heated face 100 contacted with the surface of the electronic heating component will increase the contacting area to each other and constitute a face-to-face thermal conduction.

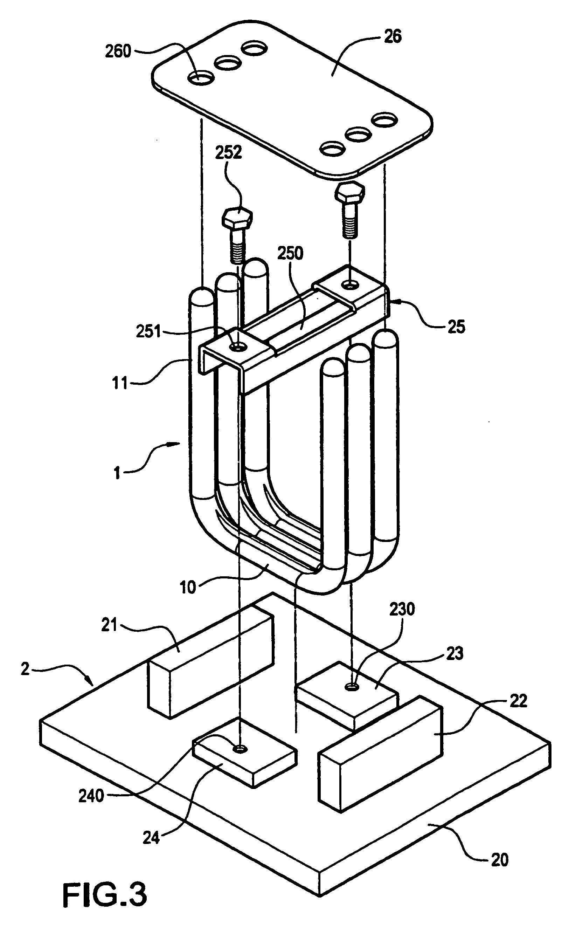

Please again refer to step S2 of Fig. 1, also as shown in Fig. 3:each heat pipes 1 are aligned vertically with their evaporators 10 drawn closely; in the meantime, the heated faces 100 of each heat pipes 1 are laid on a flat face 200. According to the invention, a fixture 2 is provided for positioning and combining each heat pipes 1. The fixture 2 includes a platform 20, a plurality of limiting blocks 21, 22, 23, 24 and a moudling 25. The surface of the platform 20 has the flat face 200, on which the plural limiting blocks 21, 22, 23, 24 are arranged, while each evaporators 10 is placed in the zone enclosed by each limiting blocks 21, 22, 23, 24 by making the heat face 100 located over the flat face 200.

Please again refer to step S3 of Fig. 1, also as shown in Fig. 3: as described thereinbefore, the evaporators 10 of each heat pipes 1 can be undergone a limiting process via each limiting blocks 21, 22,23,24 from multiple directions, thus that each evaporators 10 is positioned by each limiting blocks 21, 22, 23, 24, maintaining a configuration where each evaporators 10 is drawn and aligned closely. In this case, two pairs of the limiting blocks 21, 22, 23, 24 of the fixture 2 are formed, thus that the evaporators of the heat pipes 1 can be placed into the zone enclosed by the two pairs of limiting blocks 21, 22, 23, 24. Therefore, a limiting function from four directions is provided by the four limiting blocks 21, 22, 23, 24.

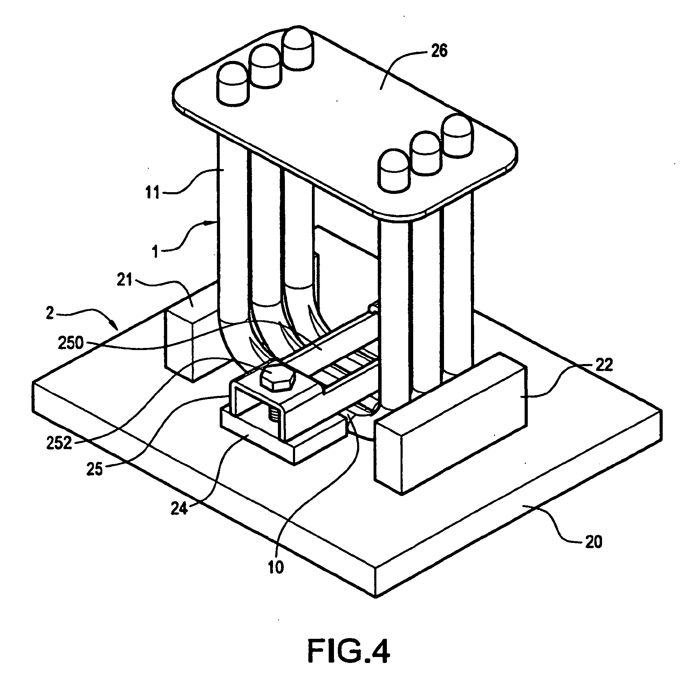

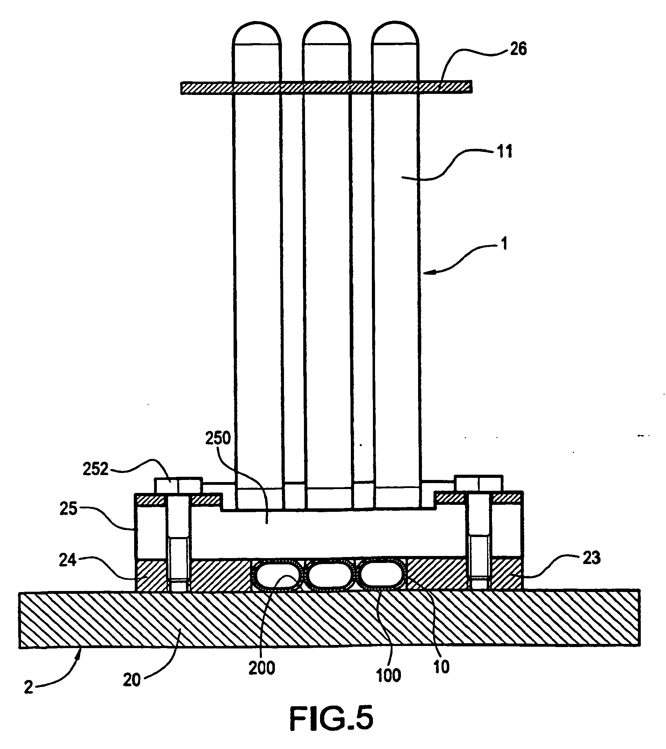

Please again refer to S4 of Fig. 1, also as shown in Fig. 4 and Fig. 5: after the evaporators 10 of each heat pipes 1 are limited in the zone enclosed by each limiting blocks 21, 22, 23, 24, the moudling 25 of the fixture 2 can load a pressure onto each evaporator 10. In other words, each heated face 100 is pressed down onto the flat face 200 of the platform 20, making the all heated face 100 flush with the flat face 200. In this case, there is a nozzle 250 arranged on the top face of the moudling 25 and overriding the two limiting blocks 23, 24 opposite to each other. The two limiting blocks 23, 24 respectively has a screwing hole 230, 240, corresponded to each of which the moudling 25 is arranged a perforation 251. Furthermore, a specific screwing component 252, such as, stud, can be adapted by penetrating the perforation 251 and being screwed in the screwing hole 230, 240, whereby the moudling 25 is fixed on the two limiting blocks 23, 24 and presses each evaporators 10 down onto the platform 20.

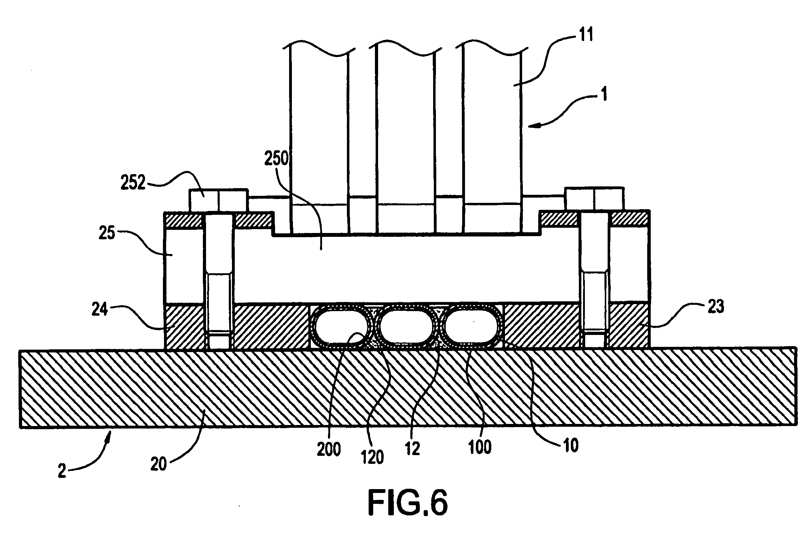

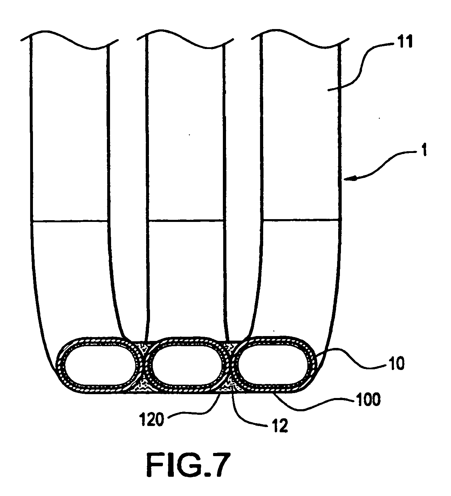

Finally, please refer to S5 of Fig. 1, also as shown in Fig. 6 and Fig. 7: via the nozzle 250 on the moudling 25, a specific boding media 12, such as, solder, is injected into the gaps among the heated faces 100 of each evaporators 10. In this step S5, the boding media 12 shown as a thick fluid flows around by filling the gaps among each evaporators 10. Via the flat face 200 of the platform 20, a connection face 120 is formed among each heated faces 100. Since the connection face 120 is configured through a match-up with the flat face 200, the connection face 120 is substantially a flat face as well. In addition, since each heated faces 100 is flush with the flat face 200 of the platform 200, the connection face 120 and each heated faces 100 constitute a coplanar configuration.

Moreover, after the evaporators 10 of each heat pipes 1 are bonded together, in order to keep the condensers 11 of each heat pipes I maintaining an arrangement of being interspaced to one another and facilitating the cooling fins to pass therethrough, in the step S1 or S2, the condensers 11 of each heat pipes 1 can be commonly arranged a spacer 26, on which a plurality of positioning holes 260 are arranged by corresponding to the disposition of each condensers 11, thus that the condensers 11 still can maintain an arrangement of being interspaced to one another, under the condition that the evaporators 10 of each heat pipes 1 can be drawn and aligned closely. In addition, since the platform 2, each limiting blocks 21, 22, 23, 24, the moudling 25 and the spacer 26 of the fixture 2 are all constituted by the materials of temperature-enduring fibers or ceramics, when the bonding media 12 is heated in the oven, the fixture 2 can stand high temperature and has sufficient strength to maintain each evaporators 10 with fixed position and configuration.

Therefore, through the constitution of aforementioned assemblies, a manufacturing method, finished product and fixture of coplanar evaporators of multiple heat pipes according to the invention are thus obtained.

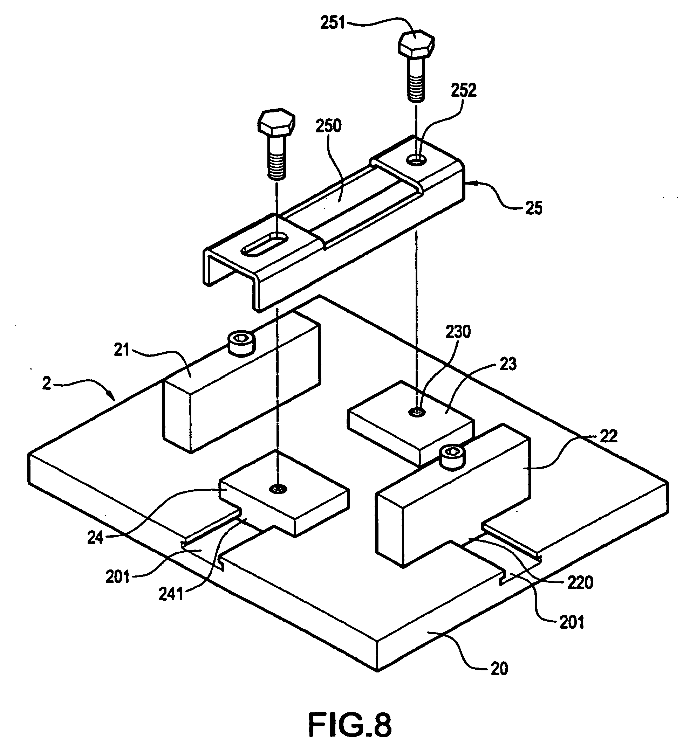

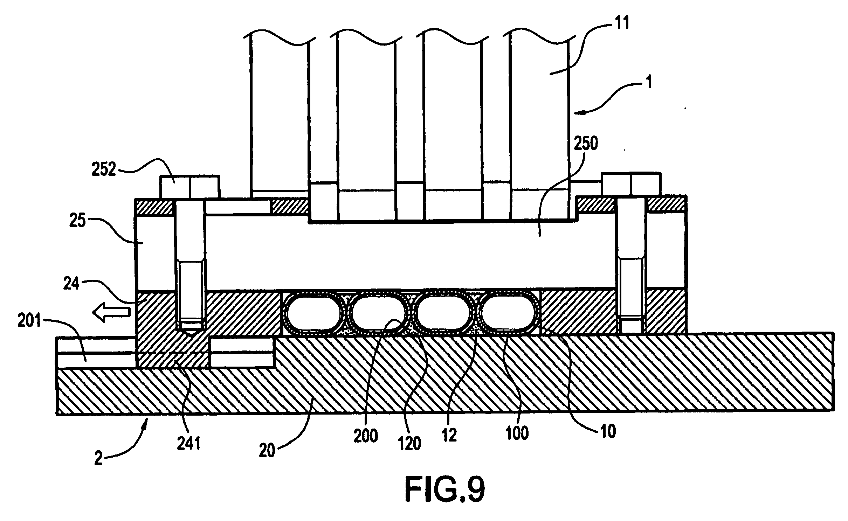

In addition, as shown in Fig. 8 and Fig. 9, each limiting blocks 21, 22, 23, 24 of the fixture 2 can also be classified into two groups: one is fixed type, and the other is movable type. Taking the embodiment proposed by the invention as an example, the quantity of the limiting blocks 21, 22, 23, 24 is four, so two pairs of opposite directions are formed after enclosed into a zone. In the two pairs of limiting blocks 21, 22, 23, 24, any two limiting blocks opposite to each other in one pair are either a fixed type or a movable type. With respect to the pair of the limiting blocks 21, 22 arranged in longitudinal direction, the platform 20 is arranged a slide 201 on the flat face 200, such that a slip part 220 is arranged under the limiting block 22 and can be slipped in the slide 201 correspondingly. On the other hand, with respect to the pair of the limiting blocks 23, 24 arranged in crosswise direction, another slip part 241 can be arranged under the limiting block 24 and slipped in the slide 201 correspondingly. Thereby, by adjusting the distance between any two limiting blocks opposite to each other, the evaporators 10 of different quantities or different radiuses can be all placed therein after being drawn and aligned closely to one another.

Therefore, in the manufacturing method, the finished product and the fixture of the coplanar evaporators of the multiple heat pipes according to the invention, the evaporators 10 of the multiple heat pipes 1 can be drawn closely to one another and fixed by a bonding media 12, thereby, the heated faces of each evaporators 10 being able to be formed into a coplanar configuration with a larger area of heat conduction, which can entirely cover the surface of the electronic component and be attached closely thereto, so the evaporator 10 of the heat pipe 1 can be directly contacted with the electronic heating component to undergo a heat transfer process.

Summarizing aforementioned description, the manufacturing method, the finished product and the fixture of the coplanar evaporators may positively reach the expected usage objective for solving the drawbacks of the prior arts.

## Claims

1. A manufacturing method of coplanar evaporators of multiple heat pipes, including following steps:
a) providing a plurality of heat pipes (I), each of which has an evaporator (10) formed a heated face (100) thereon;
b) moving the evaporators (10) closely to one another in a manner, thus their heated faces (100) being disposed onto a flat face (200);
c) limiting the evaporators (10) from multiple directions;
d) pressing the evaporators (10) toward the flat face (200) to make their heated faces (100) flush therewith;
e) injecting a bonding media (12) into gaps among the heat faces (100) of the evaporators (10) to bond the heat faces (100) together and form a fixedly coplanar configuration.

2. The manufacturing method of coplanar evaporators of multiple heat pipes according to claim 1, wherein each of the heat pipes (1) in step a) has a condenser (11), and condensers (11) are aligned to be interspaced to one another and are commonly arranged by passing through a spacer (26).

3. The manufacturing method of coplanar evaporators of multiple heat pipes according to claim 1, wherein step b) through step e) are executed via a fixture (2), including:
a platform (20), a surface of which has a flat face (200);
a plurality of limiting blocks (22), which are arranged on the flat face (200) and implement a limiting function to the evaporators (10) of the heat pipes (1) from multiple directions; and
a moudling (25), on which a nozzle (250) is arranged, and which overrides two limiting blocks (23, 24) opposite to each other for implementing a pressing function to the evaporators (10) of the heat pipes (1),
**characterized in that** a thick bonding media (12) is injected into the nozzle (250) to fill the gaps among the evaporators (10) of the heat pipes (1).

4. The manufacturing method of coplanar evaporators of multiple heat pipes according to claim 3, wherein the fixture (2) further includes a spacer (26), and each of the heat pipes (1) has a condenser (11), and condensers (11) are aligned to be interspaced to one another and are commonly arranged by passing through the spacer (26).

5. A structure of coplanar evaporators of multiple heat pipes, including a plurality of heat pipes (1), each of which has a condenser (11) and an evaporator (10) having a heated face (100), evaporators (10) being aligned closely to one another, among which a bonding media (12) is implemented, thereby, a connection face (120) being formed among each heated faces, and connection face (120) are bonded into a coplanar configuration, because of an implementation of the bonding media (12).

6. The structure of coplanar evaporators of multiple heat pipes according to claim 5, wherein the bonding material (12) is a solder.

7. A fixture for manufacturing coplanar evaporators of multiple heat pipes, adapted for aligning multiple evaporators (10) of the heat pipes (1) into a specific configuration, including:
a platform (20), a surface of which has a flat face (200);
a plurality of limiting blocks (21, 22, 23, 24), which are arranged on the flat face (200) and implement a limiting function to the evaporators (10) of the heat pipes (1) from multiple directions; and
a moudling (25), on which a nozzle (250) is arranged, and which overrides two limiting blocks (23, 24) opposite to each other for implementing a pressing function to the evaporators (10) of the heat pipes (1), whereby said nozzle (250) is suitable for injecting
a thick bonding media (12) to fill gaps among the evaporators (10) of the heat pipes (1).

8. The fixture for manufacturing coplanar evaporators of multiple heat pipes according to claim 7, wherein the moudling (25) is screwed onto the any two limiting blocks (23, 24) opposite to each other.

9. The fixture for manufacturing coplanar evaporators of multiple heat pipes according to claim 7, further including a spacer (26), on which a plurality of positioning holes (260) are arranged and adapted for the heat pipes (1) to pass therethrough.

10. The fixture for manufacturing coplanar evaporators of multiple heat pipes according to claim 9, wherein the platform (20), the limiting blocks (21, 22, 23, 24), the moudling (25) and the spacer (26) are all constituted of materials, such as, temperature-enduring fibers or ceramics.

11. The fixture for manufacturing coplanar evaporators of multiple heat pipes according to claim 7, wherein there are slides (201), which are arranged on the flat face (200) of the platform (20), and corresponded to which there are slip parts (220) arranged under the limiting blocks (20, 22) and adapted by being slipped in the slides (201)

## Patentansprüche

1. Verfahren zum Herstellen von koplanaren Verdampfern aus mehreren Wärmerohren, das die folgenden Schritte umfasst:
a) Vorsehen einer Mehrzahl von Wärmerohren (1), wovon jedes einen Verdampfer (10) aufweist, der eine darauf befindliche Wärmefläche (100) bildet;
b) Verschieben der Verdampfer (10) nahe zueinander in der Weise, dass ihre erwärmten Flächen (100) auf einer ebenen Fläche (200) angeordnet sind;
c) Begrenzen der Verdampfer (10) aus mehreren Richtungen;
d) Pressen der Verdampfer (10) auf die ebene Fläche (200), um ihre erwärmten Flächen (100) damit bündig zu machen;
e) Einspritzen eines Klebemediums (12) in Spalten zwischen den Wärmeflächen (100) der Verdampfer (10), um die Wärmeflächen (100) miteinander zu verkleben und eine starre koplanare Konfiguration zu bilden.

2. Verfahren zum Herstellen von koplanaren Verdampfern aus mehreren Wärmerohren nach Anspruch 1, wobei jedes der Wärmerohre (1) im Schritt a) einen Kühler (11) aufweist und die Kühler (11) so ausgerichtet sind, dass sie zueinander beabstandet sind, und gemeinsam angeordnet sind, indem sie durch einen Abstandshalter (26) verlaufen.

3. Verfahren zum Herstellen von koplanaren Verdampfern aus mehreren Wärmerohren nach Anspruch 1, wobei die Schritte b) bis e) über eine Befestigungseinrichtung (2) ausgeführt werden, die umfasst:
eine Plattform (20), wobei eine Oberfläche hiervon eine ebene Fläche (200) aufweist;
eine Mehrzahl von Begrenzungsblöcken (22), die auf der ebenen Fläche (200) angeordnet sind und eine Begrenzungsfunktion für die Verdampfer (10) der Wärmerohre (1) in mehreren Richtungen realisieren; und
ein Formstück (25), an dem eine Düse (250) angeordnet ist und das über zwei gegenüberliegende Begrenzungsblöcke (23, 24) hinweg reicht, um eine Pressfunktion an den Verdampfern (10) der Wärmerohre (1) auszuüben,
**dadurch gekennzeichnet, dass** ein Dickklebemedium (12) in die Düse (250) eingespritzt wird, um die Spalten zwischen den Verdampfern (10) der Wärmerohre (1) zu füllen.

4. Verfahren zum Herstellen von koplanaren Verdampfern aus mehreren Wärmerohren nach Anspruch 3, wobei die Befestigungseinrichtung (2) des Weiteren einen Abstandshalter (26) enthält und jedes der Wärmerohre (1) einen Kühler (11) aufweist und die Kühler (11) so ausgerichtet sind, dass sie zueinander beabstandet sind, und gemeinsam angeordnet sind, indem sie durch den Abstandshalter (26) verlaufen.

5. Struktur aus koplanaren Verdampfern aus mehreren Wärmerohren mit einer Mehrzahl von Wärmerohren (1), wovon jedes einen Kühler (11) und einen Verdampfer (10) mit einer Wärmefläche (100) aufweist, wobei die Verdampfer (10) nahe zueinander ausgerichtet sind, wobei zwischen ihnen ein Klebemedium (12) angeordnet ist, wodurch eine Verbindungsfläche (120) zwischen allen Wärmeflächen gebildet ist und die Verbindungsflächen (120) wegen der Verwendung des Klebemediums (12) zu einer koplanaren Konfiguration verklebt sind.

6. Struktur aus koplanaren Verdampfern aus mehreren Wärmerohren nach Anspruch 5, wobei das Klebematerial (12) ein Lötmittel ist.

7. Befestigungseinrichtung zum Herstellen von koplanaren Verdampfern aus mehreren Wärmerohren, die eingerichtet ist zum Ausrichten mehrerer Verdampfer (10) der Wärmerohre (1) in eine spezielle Konfiguration, umfassend:
eine Plattform (20), deren Oberfläche eine ebene Fläche (200) aufweist;
mehrere Begrenzungsblöcke (21, 22, 23, 24), die auf der ebenen Fläche (200) angeordnet sind und eine Begrenzungsfunktion an den Verdampfern (10) der Wärmerohre (1) in mehreren Richtungen ausüben; und
ein Formstück (25), an dem eine Düse (250) angeordnet ist und das über zwei gegenüberliegende Begrenzungsblöcke (23, 24) reicht, um eine Pressfunktion an den Verdampfern (10) der Wärmerohre (1) zu realisieren, wodurch die Düse (250) geeignet ist zum Einspritzen eines Dickklebemediums (12), um Spalte zwischen den Verdampfern (10) der Wärmerohre (1) zu füllen.

8. Befestigungseinrichtung zum Herstellen von koplanaren Verdampfern aus mehreren Wärmerohren nach Anspruch 7, wobei das Formstück (25) auf zwei gegenüberliegende Begrenzungsblöcke (23, 24) geschraubt wird.

9. Befestigungseinrichtung zum Herstellen von koplanaren Verdampfern aus mehreren Wärmerohren nach Anspruch 7, die des Weiteren einen Abstandshalter (26) enthält, an dem eine Mehrzahl von Positionierungslöchern (260) angeordnet und so beschaffen sind, dass die Wärmerohre (1) durch sie hindurchlaufen.

10. Befestigungseinrichtung zum Herstellen von koplanaren Verdampfern aus mehreren Wärmerohren nach Anspruch 9, wobei die Plattform (20), die Begrenzungsblöcke (21, 22, 23, 24), das Formstück (25) und der Abstandshalter (26) aus Werkstoffen, wie etwa temperaturbeständigen Fasern oder Keramik bestehen.

11. Befestigungseinrichtung zum Herstellen von koplanaren Verdampfern aus mehreren Wärmerohren nach Anspruch 7, wobei Gleitblöcke (201) vorhanden sind, die an der ebenen Fläche (200) der Plattform (20) angeordnet sind, und diesen entsprechend Gleitstücke (220) unter den Begrenzungsblöcken (20, 22) angeordnet sind und eingerichtet sind, in den Gleitblöcken (201) verschoben zu werden.

## Revendications

1. Procédé de fabrication d'évaporateurs coplanaires avec une multiplicité de tubes caloporteurs, incluant les étapes consistant à :
a) fournir une pluralité de tubes caloporteurs (1), dont chacun comprend un évaporateur (10) formé avec une face chauffée (100) sur lui-même ;
b) déplacer les évaporateurs (10) en rapprochement les uns des autres d'une manière telle que leurs faces chauffées (100) sont disposées sur une face plane (200) ;
c) limiter les évaporateurs (10) depuis de multiples directions ;
d) presser les évaporateurs (10) vers la face plane (200) pour amener leurs faces chauffées (100) en affleurement avec celle-ci ;
e) injecter un produit de collage (12) dans des intervalles entre les faces chauffées (100) des évaporateurs (10) pour coller les faces chauffées (100) ensemble et former une configuration coplanaire fixée.

2. Procédé de fabrication d'évaporateurs coplanaires avec une multiplicité de tubes caloporteurs selon la revendication 1, dans lequel chacun des tubes caloporteurs (1) dans l'étape a) comprend un condenseur (11), et les condenseurs (11) sont alignés pour être espacés mutuellement les uns par rapport aux autres et sont agencés de façon commune en faisant traverser un élément d'écartement (26).

3. Procédé de fabrication d'évaporateurs coplanaires avec une multiplicité de tubes caloporteurs selon la revendication 1, dans lequel les étapes b) à e) sont exécutées avec une monture (2) qui inclut :
une plate-forme (20), dont une surface présente une face plane (200) ;
une pluralité de blocs de limitation (22) qui sont agencés sur la face plane (200) et remplissent une fonction de limitation aux évaporateurs (10) des tubes caloporteurs (1) depuis de multiples directions ; et
une pièce moulée (25), sur laquelle est agencée une buse (250) et qui chevauche deux blocs de limitation (23, 24) opposés l'un à l'autre pour remplir une fonction de pressage pour les évaporateurs (10) des tubes caloporteurs (1),
**caractérisé en ce qu'**un produit de collage épais (12) est injecté dans la buse (250) pour remplir les espaces entre les évaporateurs (10) des tubes caloporteurs (1).

4. Procédé de fabrication d'évaporateurs coplanaires avec une multiplicité de tubes caloporteurs selon la revendication 3, dans lequel la monture (2) inclut en outre un élément d'écartement (26), et chacun des tubes caloporteurs (1) comprend un condenseur (11), et les condenseurs (11) sont alignés pour être écartés mutuellement les uns des autres, et sont agencés de façon commune en faisant traverser l'élément d'écartement (26).

5. Structure d'évaporateurs coplanaires avec une multiplicité de tubes caloporteurs, incluant une pluralité de tubes caloporteurs (1), chacun d'eux comprenant un condenseur (11) est un évaporateur (10) ayant une face chauffée (100), les évaporateurs (10) étant alignés proches les uns des autres, dans laquelle est intégré un produit de collage (12), grâce à quoi une face de connexion (120) est formée au niveau de chacune des faces chauffées, et une face de connexion (120) est formée par collage sous une configuration coplanaire en raison d'une mise en oeuvre du produit de collage (12).

6. Structure d'évaporateurs coplanaires avec une multiplicité de tubes caloporteurs selon la revendication 5, dans laquelle le produit de collage (12) est une soudure.

7. Monture pour fabriquer des évaporateurs coplanaires avec une multiplicité de tubes caloporteurs, adaptée pour aligner une multiplicité d'évaporateurs (10) des tubes caloporteurs (1) sous une configuration spécifique, incluant :
une plate-forme (20), dont une surface présente une face plane (200) ;
une pluralité de blocs de limitation (21, 22, 23, 24), qui sont agencés sur la face plane (200) et remplissent une fonction de limitation aux évaporateurs (10) des tubes caloporteurs (1) depuis de multiples directions ; et
un élément moulé (25), sur lequel est agencée une buse (250) et qui chevauche deux blocs de limitation (23, 24) opposés l'un à l'autre pour remplir une fonction de pressage aux évaporateurs (10) des tubes caloporteurs (1), grâce à quoi ladite buse (250) est appropriée pour injecter un produit de collage épais (12) et remplir des intervalles entre les évaporateurs (10) des tubes caloporteurs (1).

8. Monture pour fabriquer des évaporateurs coplanaires avec une multiplicité de tubes caloporteurs, selon la revendication 7, dans laquelle l'élément moulé (25) est vissé sur deux quelconques blocs de limitation (23, 24) opposés l'un à l'autre.

9. Monture pour fabriquer des évaporateurs coplanaires avec une multiplicité de tubes caloporteurs selon la revendication 7, incluant en outre un élément d'écartement (26), sur lequel sont ménagés une pluralité de trous de positionnement (260) et adaptés pour que les tubes caloporteurs (1) passent à travers.

10. Monture pour fabriquer des évaporateurs coplanaires avec une multiplicité de tubes caloporteurs selon la revendication 9, dans laquelle la plate-forme (20), les blocs de limitation (21, 22, 23, 24), l'élément moulé (25) et l'élément d'écartement (26) sont tous constitués de matériaux comme par exemple des fibres ou des céramiques résistant à la température.

11. Monture pour fabriquer des évaporateurs coplanaires avec une multiplicité de tubes caloporteurs selon la revendication 7, dans laquelle sont prévus des coulisseaux (201), qui sont agencés sur la face plane (200) de la plate-forme (20) et en correspondance desquels sont prévues des pièces coulissantes (220) agencées sous les blocs de limitation (20, 22) et adaptées à être glissées dans les coulisseaux (201).
